# EUROPÄISCHE PATENTSCHRIFT

(11) **EP 3 308 231 B1**
(45) Veröffentlichungstag und Bekanntmachung des Hinweises auf die Patenterteilung: **18.09.2019**
(21) Anmeldenummer: 16730786.7
(22) Anmeldetag: 13.06.2016
(51) Int. Cl.: G05B 23/02, B23K 9/095, B23K 37/00, B23K 1/00, H05K 7/20, B23K 9/10

(54) **GERÄT MIT ÜBERWACHTER GERÄTKÜHLUNG**
DEVICE WITH MONITORED DEVICE COOLING
APPAREIL DOTÉ D'UN REFROIDISSEMENT SURVEILLÉ

(30) Priorität: 15.06.2015 EP 15172103
(43) Veröffentlichungstag der Anmeldung: 18.04.2018
(73) Patentinhaber: Fronius International GmbH, 4643 Pettenbach (AT)
(72) Erfinder: LANZ, Bernhard, 4866 Unterach (AT); EDER, Alexander, 4732 St. Thomas (AT); LUGMAYR, Andreas, 4540 Pfarrkirchen bei Bad Hall (AT)
(74) Vertreter: Isarpatent
(86) Internationale Anmeldenummer: PCT/EP2016/063463
(87) Internationale Veröffentlichungsnummer: WO 2016/202726

(56) Entgegenhaltungen:
- DE-A1- 19 626 059
- DE-A1-102005 058 351
- DE-A1-102012 013 104
- US-A1- 2009 299 531

## Beschreibung

Die Erfindung betrifft ein Gerät mit überwachter Gerätkühlung sowie ein Verfahren zum Überwachen eines Betriebszustandes einer Gerätkühlung bei einem Gerät, insbesondere bei einem Energiegerät, das einen elektrischen Strom bereitstellt oder umwandelt. Derartige Energiegeräte umfassen Batterieladegeräte, Wechselrichter und Schweißgeräte.

Schweißgeräte verfügen über eine Schweißstromquelle, welche einen elektrischen Strom zur Durchführung des Schweißvorganges liefert. Ein Schweißinverter stellt eine elektronische Schweißstromquelle dar. Inverterschweißgeräte werden für verschiedene Lichtbogenschweißverfahren, wie beispielsweise Elektroden-, MIG/MAG-, Plasma- und WIG/TIG-Schweißen, eingesetzt. Derartige Geräte werden je nach Leistung ein- oder dreiphasig an ein Stromnetz angeschlossen. Bei einem Schweißinverter wird die Netzspannung zuerst gleichgerichtet und mithilfe von Leistungshalbleitern zerhackt und mittels eines relativ kleinen Transformators auf eine geringe Spannung transformiert. Anschließend wird der Schweißstrom mittels geeigneter Dioden gleichgerichtet.

Energiegeräte, insbesondere Schweißstromquellen, können eine Vielzahl unterschiedlicher elektronischer bzw. elektromechanischer Bauteile umfassen. Die Leistung und Einschaltdauer der Schweißstromquelle wird durch die zulässigen Bauteiltemperaturen im Gerät begrenzt. Ist eine Grenztemperatur erreicht, schaltet das Gerät ab, bis das betreffende Bauteil wieder abgekühlt ist. Herkömmliche Schweißgeräte können über eine Überwachungselektronik verfügen. Die DE 196 260 59 A1 beschreibt eine Schweißvorrichtung mit einer Überwachungselektronik, die bei Überschreiten eines Sollwertes ein Signal zu einem Schaltelement abgibt, um einen Schaltvorgang auszulösen. Auf diese Weise kann bei Auftreten eines Defektes innerhalb der Schweißvorrichtung das Bedienpersonal vor Gefah-Gefahren geschützt werden. Beispielsweise kann bei Erreichen einer Grenztemperatur die Schweißvorrichtung abgeschaltet werden.

Bei Schweißgeräten kann es allerdings vorkommen, dass aufgrund einer Beeinträchtigung der Schweißgerätkühlung die Temperatur innerhalb des Gehäuses des Schweißgerätes erhöht ist, ohne dass Grenztemperaturen erreicht werden. Ist die Kühlung des Schweißgerätes beeinträchtigt, erhöht sich die mittlere Temperatur innerhalb des Gerätes, sodass die Lebensdauer einzelner Bauteile bzw. Bauelemente und somit die Lebensdauer des Gerätes vermindert wird. Ist die Gerätkühlung beeinträchtigt wird die Grenztemperatur früher erreicht, wodurch die vom Hersteller angegebene Einschaltdauer nicht mehr eingehalten wird, da das Gerät nach kurzer Schweißdauer abschaltet. Die Schweißstromquelle ist häufig räumlich distanziert oder getrennt vom Schweißprozess. Daher ist es beim Schweißen, ob manuell oder automatisiert mit Roboter, eine Beeinträchtigung der Schweißgerätekühlung z.B durch zu hohe Umgebungstemperatur nicht offensichtlich.
Durch Vornahme von regelmäßigen Wartungsarbeiten, beispielsweise dem Reinigen einer Kühlluftstrecke, kann dem zwar entgegengewirkt werden, jedoch ist der dafür erforderliche Arbeits- und Zeitaufwand erheblich, insbesondere auch zum Auffinden der für die Beeinträchtigung der Kühlung maßgeblichen Ursache.

DE 10 2005 058 351 A1 offenbart ein Verfahren zum Überwachen eines Schweißinverters zum Widerstandsschweißen, wobei ein Temperaturverlauf zum Überwachen des Schweißinverters, insbesondere zum Durchführen einer Lebensdauerabschätzung, aufgenommen wird.

US 2009/299531 A1 offenbart eine elektronische Vorrichtung mit einer Abweichungswertberechnungseinheit, die einen Abweichungswert von der normalen Grenze des Verhältnisses zwischen einem der Antriebsleistung zugeordneten Leistungsindex und der gemessenen Drehzahl des Ventilators berechnet, einer Verstopfungserfassungseinheit, die anhand des Abweichungswerts Verstopfungen in einem Luftkanal erfasst, durch den der Ventilator Luft außerhalb des Gehäuses ansaugt und an den Heizkörper sendet, und einer Abweichungswertkorrektureinheit, die den Abweichungswert entsprechend der Alterung der Leistung des Ventilators korrigiert, um eine durch die Alterung hervorgerufene Verschlechterung der Verstopfungserfassungskapazität der Verstopfungserfassungseinheit auszugleichen.

Es ist daher eine **Aufgabe** der vorliegenden Erfindung, eine Vorrichtung und ein Verfahren zu schaffen, die es erlauben, den Wartungsaufwand bei einem Energiegerät hinsichtlich der Gerätkühlung zu reduzieren.

Diese Aufgabe wird erfindungsgemäß durch ein Gerät mit den in Patentanspruch 1 angegebenen Merkmalen gelöst.

Bei einer weiteren möglichen Ausführungsform des erfindungsgemäßen Gerätes weist das Gerät eine Nutzerschnittstelle auf, welche eine Anzeigeeinheit zur Anzeige der Betriebszustandsabweichung der Gerätkühlung, der ermittelten Ursache der Betriebszustandsabweichung und Anweisungen zur Behebung der ermittelten Ursache der Betriebszustandsabweichung der Gerätkühlung aufweist.

Bei einer weiteren möglichen Ausführungsform des erfindungsgemäßen Gerätes weist die Nutzerschnittstelle ferner eine Eingabeeinheit zur Einstellung des Stromes durch einen Nutzer und/oder durch eine zentrale Steuerung einer Anlage auf.

Bei einer weiteren möglichen Ausführungsform des erfindungsgemäßen Gerätes weisen die Bauteile elektronische und/oder elektromechanische Bauteile auf, die zugehörige Kühleinheiten zur Kühlung des jeweiligen Bauteils besitzen.

Bei einer weiteren möglichen Ausführungsform des erfindungsgemäßen Gerätes weist die Gerätkühlung als Bauteil mindestens eine Lüftungseinheit auf, die Kühlluft aus der Umgebung des Gerätes weiteren Bauteilen entlang einer Kühlluftstrecke innerhalb eines Gehäuses des Gerätes zuführt.

Bei einer weiteren möglichen Ausführungsform des erfindungsgemäßen Gerätes weisen die Bauteile entlang der Kühlluftstrecke zugehörige Temperatursensoren auf, die einen Betriebstemperaturverlauf an den jeweiligen Bauteilen erfassen und an die Überwachungseinheit des Gerätes melden.

Bei einer weiteren möglichen Ausführungsform des erfindungsgemäßen Gerätes weist dieses eine Strommesseinheit auf, welche den eingestellten Strom misst und an die Überwachungseinheit meldet.

Bei einer weiteren möglichen Ausführungsform des erfindungsgemäßen Gerätes steuert die Überwachungseinheit in Abhängigkeit von dem momentanen Betriebszustand der Gerätkühlung mindestens einen Aktuator, insbesondere eine Kühleinheit und/oder eine Lüftungseinheit, an.

Bei einer weiteren möglichen Ausführungsform des erfindungsgemäßen Gerätes hat die Überwachungseinheit Zugriff auf einen Datenspeicher, der ein Datenmodell des Gerätes, insbesondere ein Datenmodell der darin enthaltenen Bauteile und deren räumliche Lage entlang der Kühlluftstrecke, speichert.

Bei einer weiteren möglichen Ausführungsform des erfindungsgemäßen Gerätes meldet die Überwachungseinheit über eine Netzwerkschnittstelle des Gerätes den Betriebszustand der Gerätkühlung an eine zentrale Steuerung einer Anlage.

Die Erfindung schafft ferner ein Verfahren zum Überwachen eines Betriebszustandes einer Gerätkühlung bei einem Gerät mit den in Patentanspruch 10 angegebenen Merkmalen.

Bei einer weiteren möglichen Ausführungsform des erfindungsgemäßen Verfahrens werden eine Betriebszustandsabweichung der Gerätkühlung und mindestens eine erkannte potentielle Ursache der Betriebszustandsabweichung sowie Anweisungen zur Behebung der entsprechenden Ursache über eine Nutzerschnittstelle und/oder eine Netzwerkschnittstelle des Gerätes ausgegeben.

Im Weiteren werden mögliche Ausführungsformen des erfindungsgemäßen Gerätes und des erfindungsgemäßen Verfahrens zur Überwachung eines Betriebszustandes einer Gerätkühlung bei einem Gerät unter Bezugnahme auf die beigefügten Figuren näher erläutert.

Es zeigen:
- Fig. 1: ein Blockschaltbild zur schematischen Darstellung eines Ausführungsbeispiels eines erfindungsgemäßen Gerätes;
- Fig. 2: ein Ablaufdiagramm zur Darstellung eines Ausführungsbeispiels des erfindungsgemäßen Verfahrens zum Überwachen eines Betriebszustandes einer Gerätkühlung bei einem Gerät;
- Figuren 3, 4, 5, 6: Temperaturverläufe zur Erläuterung der Funktionsweise des erfindungsgemäßen Gerätes und des erfindungsgemäßen Verfahrens zum Überwachen eines Betriebszustandes einer Gerätkühlung bei einem Gerät.

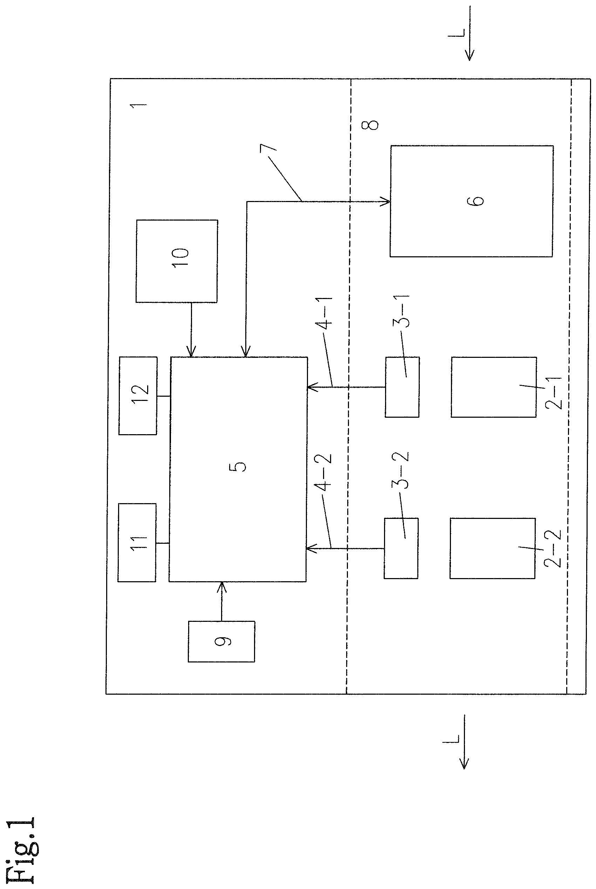

Fig. 1 zeigt ein schematisches Blockschaltbild zur Darstellung eines Ausführungsbeispiels eines erfindungsgemäßen Gerätes 1. Bei dem Gerät 1 handelt es sich bei einer möglichen Ausführungsform um ein Schweißgerät, das einen Schweißbrenner mit einem einstellbaren elektrischen Strom versorgt. Das Schweißgerät 1 kann eine Vielzahl unterschiedlicher Bauelemente bzw. Bauteile enthalten, welche zum einen als Steuerelektronik und zum anderen für leistungselektronische Zwecke eingesetzt werden. Diese Bauteile bzw. Bauelemente umfassen beispielsweise elektronische oder elektromechanische Bauteile. Fig. 1 zeigt schematisch zwei Bauteile 2-1, 2-2, bei denen es sich beispielsweise um elektronische Bauteile oder elektronische Baugruppen handelt. Die beiden Bauteile bzw. Baugruppen 2-1, 2-2 haben eine Betriebstemperatur T, die bei der dargestellten Ausführungsform über einen zugehörigen Temperatursensor 3-1, 3-2 erfasst wird. Die Temperatursensoren erfassen jeweils einen Betriebstemperaturverlauf T(t) des zugehörigen Bauteils bzw. der zugehörigen Baugruppe, insbesondere einem Leistungsteil, innerhalb des Schweißgerätes 1. Die Temperatursensoren 3-1, 3-2 können direkt an dem zugehörigen Bauteil 2-1, 2-2 angebracht sein oder sich in unmittelbarer räumlicher Nähe des betreffenden Bauteils 2-i befinden. Bei einer weiteren möglichen Ausführungsform verfügen die Bauteile bzw. Baugruppen 2-i jeweils über mindestens einen integrierten Temperatursensor 3-i, welcher den Betriebstemperaturverlauf T(t) des betreffenden Bauteils 2-i sensorisch erfasst. Die integrierten Temperatursensoren 3-i sind über Signalleitungen 4-1, 4-2 an eine Überwachungseinheit 5 angeschlossen. Die Temperatursensoren 3-1, 3-2 übertragen den Betriebstemperaturverlauf T(t) des zugehörigen Bauteils 2-i an die Überwachungseinheit 5. Die Überwachungseinheit 5 überwacht auf Basis der erfassten Betriebstemperaturverläufe und eines eingestellten Schweißstromes I des Schweißgerätes 1 den Betriebszustand einer Schweißgerätkühlung des Schweißgerätes 1.
Bei dem in Fig. 1 dargestellten Ausführungsbeispiel enthält das Schweißgerät 1 eine Lüftungseinheit 6, die an die Überwachungseinheit 5 über Leitungen 7 angeschlossen ist. Die Lüftungseinheit 6 bzw. der Ventilator zieht kühlende Umgebungsluft aus der Umgebung des Schweißgerätes 1 an, wobei die kühlende Luft L entlang einer Kühlluftstrecke 8 innerhalb des Schweißgerätes 1 an den Bauteilen 2-1, 2-2 und/oder an den Kühlrippen eines für die Bauteilkühlung vorgesehenen Kühlkörpers zu deren Kühlung vorbeistreicht und an einer anderen Stelle aus dem Gehäuse des Schweißgerätes 1 heraustritt, wie schematisch in Fig. 1 dargestellt. Die Lüftungseinheit 6 kann beispielsweise auch Teil einer Flüssigkeitskühlung sein, indem mit der Umgebungsluft - beispielsweise über einen Wärmetauscher - die Flüssigkeit gekühlt wird.
Die Schweißgerätkühlung umfasst bei dem dargestellten Beispiel die Lüftungseinheit 6 zur Kühlung der Bauteile 2-1, 2-2. Bei einer möglichen Ausführungsform weisen die elektronischen bzw. elektromechanischen Bauteile 2-i zudem jeweils zugehörige Kühleinheiten zur Kühlung des jeweiligen Bauteils 2-i auf. Diese Kühleinheiten sind beispielsweise Kühlkörper, die an dem jeweiligen Bauteil 2-i angebracht bzw. angeschraubt sind. Die Bauteile 2-i entlang der Kühlluftstrecke 8 weisen vorzugsweise jeweils einen zugehörigen Temperatursensor 3-i auf, der einen Betriebstemperaturverlauf T(t) an dem jeweiligen Bauteil 2-i an die Überwachungseinheit 5 des Schweißgerätes 1 meldet. Die Übertragung der Betriebstemperaturdaten erfolgt über die Signalleitungen 4-i. Die Temperatursensoren 3-i erfassen vorzugsweise kontinuierlich die Betriebstemperatur des jeweiligen zugehörigen Bauteils 2-i. Auf Grundlage des von dem Schweißgerät 1 bereitgestellten Schweißstromes bzw. der Schweißleistung kann die Überwachungseinheit 5 den zu erwartenden Betriebszustand der Schweißgerätkühlung ableiten bzw. ermitteln, sodass diese als Referenzwerte dienen. Die aktuell von den Temperatursensoren 3-i gemeldeten Betriebstemperaturverläufe T(t) an den Bauteilen 2-i innerhalb der Kühlstrecke 8 können durch die Überwachungseinheit 5 mit den erwarteten Betriebstemperaturverläufen verglichen werden. Bei einer nach dem Vergleich des überwachten Betriebszustandes der Schweißgerätkühlung mit dem normalen, erwarteten Betriebszustand der Schweißgerätkühlung resultierenden Abweichung führt die Überwachungseinheit 5 eine Analyse der erfassten Betriebstemperaturverläufe verschiedener Bauteile 2-i zur Ermittlung mindestens einer potentiellen Ursache der aufgetretenen Betriebszustandsabweichung durch.

Bei einer möglichen Ausführungsform verfügt das Schweißgerät 1 zusätzlich über mindestens einen weiteren Temperatursensor 9, welcher eine in der Umgebung des Schweißgerätes 1 herrschende Umgebungstemperatur an die Überwachungseinheit 5 des Schweißgerätes 1 meldet. Der Umgebungstemperatursensor 9 kann dabei außen am Gehäuse und/oder direkt an der Innenseite des Gehäuses angeordnet sein. Somit werden auch Faktoren wie eine direkte Sonneneinstrahlung bzw. Wettereinflüsse allgemein auf das Schweißgerät 1 berücksichtigt. Dies kann auch gegebenenfalls in Abhängigkeit der Tageszeit geschehen.
Diese Umgebungstemperatur wird vorzugsweise durch die Überwachungseinheit 5 zur Durchführung der Analyse mitberücksichtigt. Das Schweißgerät bzw. die Stromquelle 1 liefert einen Schweißstrom I an eine externe Schweißeinheit, insbesondere einem Schweißbrenner. Der von dem Schweißgerät 1 gelieferte Strom I wird bei einer möglichen Ausführungsform durch eine in dem Schweißgerät 1 integrierte Strommesseinheit 10 gemessen und der Überwachungseinheit 5 als Parameter gemeldet. Anhand dieses zusätzlichen Parameters kann die Überwachungseinheit 5 den normal zu erwartenden Betriebszustand ermitteln. Als Parameter können anstelle oder zusätzlich auch Parameter wie Spannungsverläufe, Regler Zustände, konstant Strom / konstant Spannungskennlinie bzw. andere dynamische Vorgänge, die ausgewählte Schweißkennlinie usw. herangezogen werden.

Bei dem in Fig. 1 dargestellten Ausführungsbeispiel verfügt das Schweißgerät 1 über eine Nutzerschnittstelle 11 für einen Nutzer des Schweißgerätes 1, beispielsweise ein Schweißer. Die Nutzerschnittstelle 11 weist vorzugsweise eine Anzeigeeinheit auf, die zur Anzeige einer Betriebszustandsabweichung der Schweißgerätkühlung, einer ermittelten Ursache der Betriebszustandsabweichung sowie zur Ausgabe von Anweisungen zur Behebung der ermittelten Ursache der Betriebszustandsabweichung aufgrund der durchgeführten Analyse dient. Die Nutzerschnittstelle 11 kann auch eine Eingabeeinheit zur Einstellung des Schweißstromes I durch den Nutzer aufweisen. Das Schweißgerät 1 verfügt bei einer möglichen Ausführungsform ferner über eine Netzwerkschnittstelle 12, die das Schweißgerät 1 über ein Netzwerk, insbesondere ein Datennetzwerk, mit einer zentralen Steuerung einer Anlage verbindet. Diese zentrale Steuerung kann bei einer möglichen Ausführungsform verschiedene Geräte, insbesondere Schweißgeräte 1, überwachen und steuern. Bei einer möglichen Ausführungsform meldet die Überwachungseinheit 5 über die Netzwerkschnittstelle 12 des Schweißgerätes 1 den Betriebszustand der Schweißgerätkühlung des Schweißgerätes 1 an die zentrale Steuerung der Anlage.

Bei einer möglichen Ausführungsform steuert die Überwachungseinheit 5 in Abhängigkeit von dem momentanen Betriebszustand der Schweißgerätkühlung mindestens einen Aktuator des Schweißgerätes 1. Bei einer möglichen Ausführungsform steuert die Überwachungseinheit 5 in Abhängigkeit von dem momentanen Betriebszustand der Schweißgerätkühlung die Kühleinheit innerhalb des Schweißgerätes 1 oder eine Lüftungseinheit, beispielsweise den Ventilator 6, entsprechend dem momentanen Betriebszustand der Schweißgerätkühlung an. Bei einer möglichen Ausführungsform hat die Überwachungseinheit 5 zudem Zugriff auf einen Datenspeicher, der ein Datenmodell des Schweißgerätes 1 speichert. Dieses gespeicherte Datenmodell umfasst vorzugsweise die in dem Schweißgerät 1 enthaltenen Bauteile bzw. Baugruppen 2-i und deren absolute oder relative räumliche Lage zueinander entlang der Kühlluftstrecke 8. Das Datenmodell umfasst beispielsweise auch Referenzwerte, wie sich die Kühlluftstrecke 8 bei unterschiedlichen Umgebungstemperaturen verhält.

Die Überwachungseinheit 5 kann bei einer möglichen Ausführungsform einen oder mehrere Mikroprozessoren enthalten, welche ein Überwachungsprogramm ausführen. Die Überwachungseinheit 5 - welche auch in der Steuerung der Stromquelle integriert sein kann - führt eine intelligente Auswertung der von den Temperatursensoren 3-i gelieferten Temperaturverläufe innerhalb des Schweißgerätes 1 aus und führt eine Analyse durch, warum die Kühlleistung innerhalb der Kühlluftstrecke 8 abgenommen hat. Die Analyse der Schweißgerätkühlung wird durch die Überwachungseinheit 5 durchgeführt, um potentielle Ursachen für diese Betriebszustandsabweichung herauszufinden. Die Überwachungseinheit 5 meldet über die Anzeigeeinheit der Nutzerschnittstelle 11 die aufgetretene Betriebszustandsabweichung der Schweißgerätkühlung und gibt gleichzeitig Hinweise zur Behebung der ermittelten potentiellen Ursache für diese Betriebszustandsänderung. Durch diese Art der Zustandsüberwachung bzw. Condition Monitoring ist es möglich, die Wartungsintervalle zur Wartung des Schweißgerätes 1 zu verlängern. Bei Auftreten einer Betriebszustandsänderung erhält der Nutzer zudem eine exakte Fehlerbeschreibung und Anweisungen zur Behebung der ermittelten potentiellen Fehlerursache. Hierdurch wird die Wartung des Schweißgerätes 1 hinsichtlich seiner Kühlung erheblich vereinfacht und die Dauer der Wartung verkürzt. Mit dem erfindungsgemäßen Gerät 1 und dem erfindungsgemäßen Verfahren wird der Betriebszustand der Gerätkühlung überwacht, sodass aufgetretene Fehler frühzeitig erkannt werden, d.h. nicht erst bei Überschreiten von Grenztemperaturen. Die daraus resultierende frühzeitige Behebung der defekten Kühlung führt dazu, dass die in dem Gerät 1 enthaltenen Bauteile 2-i durchschnittlich einer geringeren mittleren Temperatur ausgesetzt sind und somit eine deutlich höhere Betriebslebenserwartung haben. Hierdurch wird die Lebensdauer bzw. Betriebszeit des Gerätes 1 insgesamt deutlich gesteigert.
Es wird also die Beeinträchtigung der Kühlleistung dem Bediener frühzeitig angezeigt (z.B. mit Farben), wodurch dieser auf die maximal mögliche Einschaltdauer rückschließen kann. Das ist für einen Schweißprozess ausschlaggebend, ob eine Schweißung ohne Unterbrechung durchgeführt werden kann. Es muss demnach die eingestellte Leistung über die gesamte Dauer der Schweißung zur Verfügung stehen. Somit kann ein unerwarteter Abbruch von Schweißprozessen verhindert werden und dadurch Ausschussteile vermieden werden.

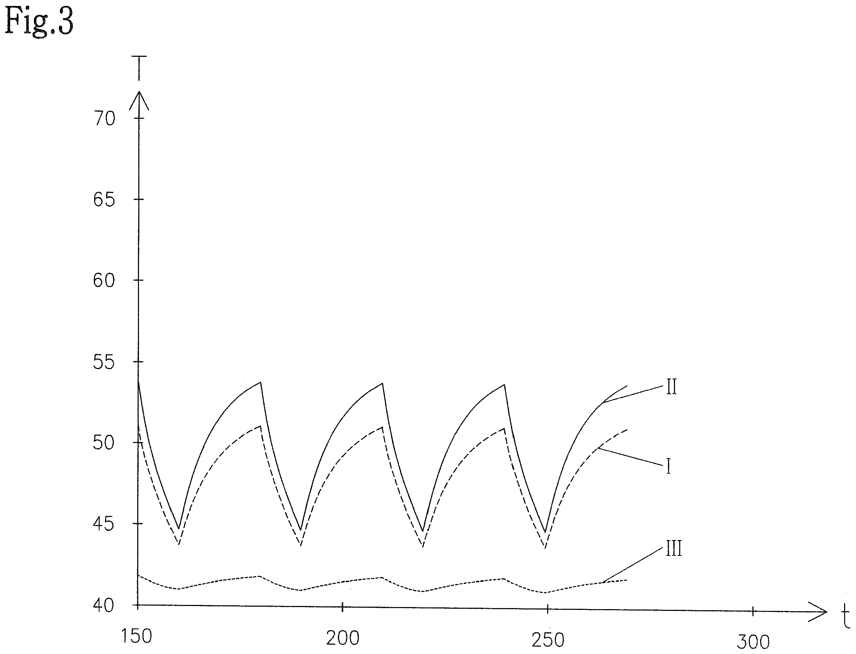

Die Funktionsweise des erfindungsgemäßen Gerätes 1 und des erfindungsgemäßen Verfahrens zur Überwachung eines Betriebszustandes einer Gerätkühlung wird im Folgenden unter Bezugnahme auf die in den Figuren 3 bis 6 dargestellten Temperaturverläufe beispielhaft erläutert. Die Diagramme zeigen die Temperatur T von Bauteilen, beispielsweise der in Fig. 1 dargestellten Bauteile 2-1, 2-2, über die Zeit t. Die dort dargestellten Temperaturverläufe können durch Temperatursensoren, beispielsweise die in Fig. 1 dargestellten Temperatursensoren 3-1, 3-2, aufgezeichnet werden.

Fig. 3 zeigt einen beispielhaften Temperaturverlauf T(t) bei einem Schweißgerät 1 mit funktionierender Kühlung bei einer Umgebungstemperatur von 40°C. Im Normalbetrieb des Schweißgerätes 1 weist dieses eine gegenüber der Umgebungstemperatur leicht erhöhte relativ konstante Temperatur von beispielsweise etwa 42°C auf, wie in Fig. 3 durch Kurve III dargestellt. Die Kurven I, II zeigen den Temperaturverlauf von zwei Bauteilen innerhalb des Schweißgerätes 1, beispielsweise der Bauteile 2-1, 2-2 in Fig. 1. Wie man in Fig. 3 erkennen kann, ist der Temperaturverlauf bei beiden Bauteilen 2-i periodisch, wobei die Betriebstemperatur während eines Schweißzeitraums ansteigt und während einer darauffolgenden Schweißpause abfällt.

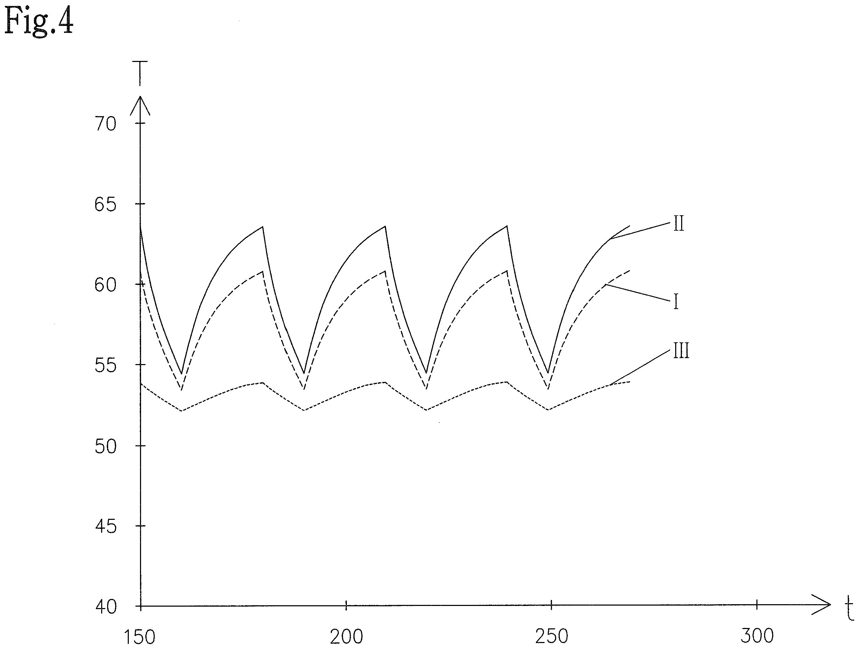

Fig. 4 zeigt die Temperaturverläufe T(t) bei einer erhöhten Umgebungstemperatur von 50°C bei funktionierender Kühlung des Schweißgerätes 1. Die Umgebungstemperatur wird beispielsweise durch den Umgebungstemperatursensor 9 der Überwachungseinheit 5 gemeldet. Entsprechend sind die Verläufe der Kurven I bis III wie bei Fig. 3, jedoch um den Wert der höheren Umgebungstemperatur nach oben verschoben. Beispielsweise liegt also die Temperatur im Normalbetrieb bei ca. 55°C.

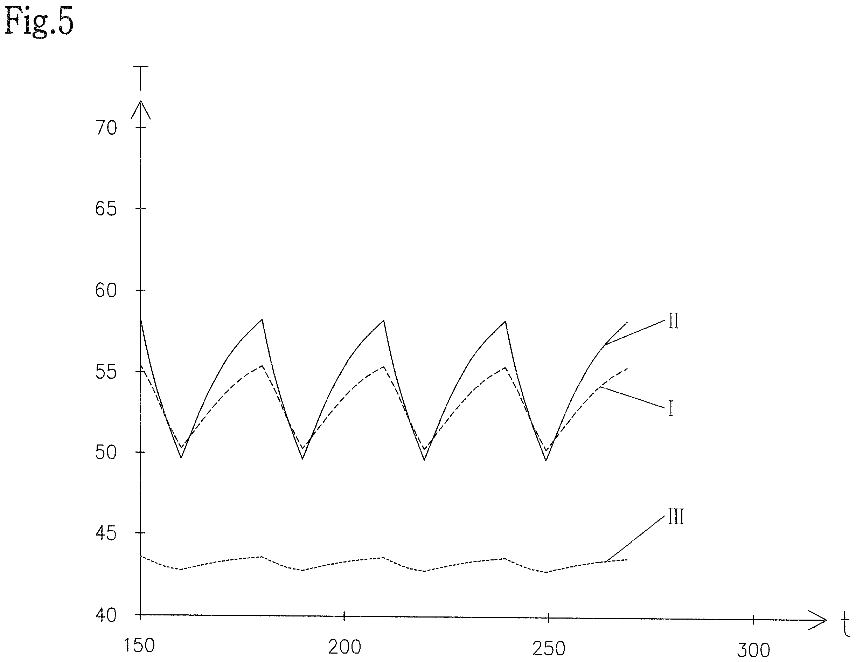

Fig. 5 zeigt die Temperaturverläufe T(t) an den beiden Bauteilen 2-1, 2-2 bei einer Umgebungstemperatur von 40°C bei blockierter Kühlluftzufuhr. Wie man aus Fig. 5 erkennen kann, liegt die Temperatur T innerhalb des Schweißgerätes 1 außerhalb der Kühlluftstrecke 8 innerhalb des Gehäuses des Schweißgerätes 1 leicht über dem Temperaturverlauf in Fig. 3 (Kurve III), während die von den Temperatursensoren 3-1, 3-2 der beiden Bauteile 2-1, 2-2 gemeldeten Temperaturverläufe beide deutlich erhöht sind. Dies ist ein klarer Hinweis, dass die Kühlluftzufuhr innerhalb der Kühlstrecke 8 innerhalb des Schweißgerätes 1 aufgrund eines fehlerhaften Lüfters 6 blockiert ist. Aufgrund des fehlerhaften Lüfters 6 verschieben sich die Temperaturverläufe T(t) der beiden in der Kühlluftstrecke 8 enthaltenen Bauteile 2-1, 2-2 (Kurve I, Kurve II) parallel nach oben.

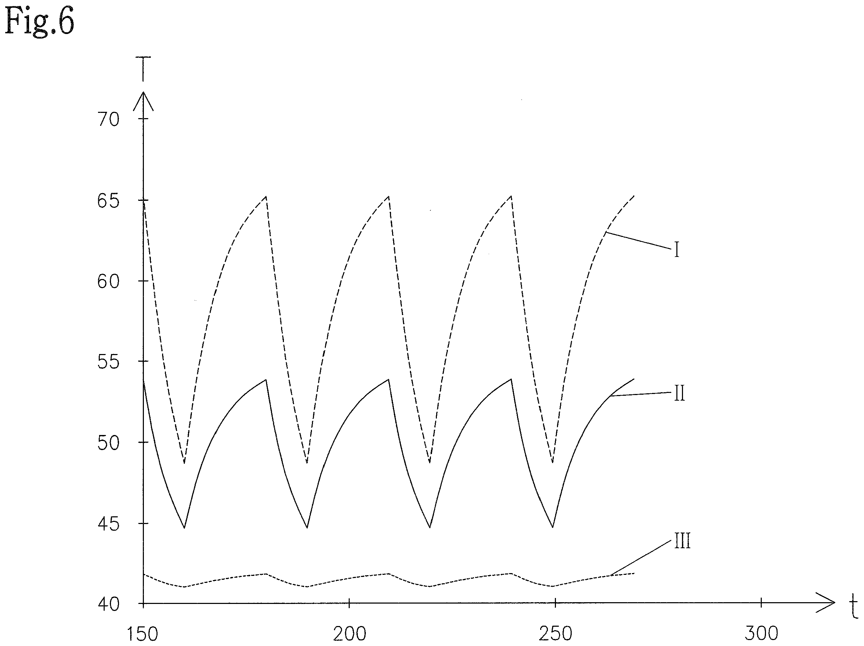

Fig. 6 zeigt die Temperaturverläufe T(t) bei einer Umgebungstemperatur von 40°C nach Auftreten eines anderen Fehlers. Wie man in Fig. 6 erkennen kann (Kurve I), ist der Temperaturverlauf, welcher von dem Sensor 3-1 des ersten Bauteils 2-1 an die Überwachungseinheit 5 übertragen wird, im Vergleich zu dem Temperaturverlauf gemäß Fig. 3 deutlich erhöht. Zusätzlich sind die Temperaturschwankungen an dem ersten Bauteil 2-1 im Vergleich zu den Temperaturschwankungen an dem anderen Bauteil 2-2 (Kurve II) deutlich größer. Aus dem in Fig. 6 dargestellten Temperaturverlauf kann die Überwachungseinheit 5 auf einen Fehler bei der Kühleinheit des ersten Bauteils 2-1 (Kurve I) schließen. Verfügt dieses Bauteil 2-1 beispielsweise über einen Kühlkörper, der an das Bauteil 2-1 angeschraubt ist, kann aus dem in Fig. 6 dargestellten Temperaturverlauf geschlossen werden, dass vermutlich die Schraubverbindung zwischen dem Kühlkörper und dem zugehörigen Bauteil 2-1 locker ist. In diesem Falle kann ein Nutzer beispielsweise hinsichtlich der Wartung den Hinweis erhalten, die Kühleinheit des Bauteils 2-1 zu überprüfen und ggf. den Kühlkörper fester an das betroffene Bauteil 2-1 anzuschrauben.

Die Überwachungseinheit 5 kann die Analyse der verschiedenen Temperaturverläufe T(t) unter Berücksichtigung der Umgebungstemperatur T_{U} und der momentan abgegebenen Schweißleistung durchführen, um mögliche Abweichungen von einem normalen Betriebszustand der Kühlung zu erkennen. Sobald eine Betriebszustandsabweichung der Kühlung des Schweißgerätes 1 erkannt wird, kann durch Analyse der Temperaturverläufe T(t), der Umgebungstemperatur T_{U}(t), der Drehzahl des Ventilators 6 und/oder des abgegebenen Schweißstromes I gemäß der Schweißleistung eine Analyse vorgenommen werden, welche mögliche Fehlerursachen für die aufgetretenen Temperaturverläufe verantwortlich sind. Bei der Aufzeichnung der Temperaturverläufe können auch die Abkühlzeiten erfasst werden. Aus der Abkühlzeit kann der Betriebszustand der Kühlung ermittelt bzw. abgeleitet werden. Dazu können beispielsweise Referenzwerte abgespeichert sein.

Bei einer möglichen Ausführungsform kann die Überwachungseinheit 5 verschiedene mögliche Fehlerursachen entsprechend ihrer Wahrscheinlichkeit sortieren und über die Nutzerschnittstelle 11 dem Nutzer anzeigen. Bei einer möglichen besonderen Ausführungsform hat die Überwachungseinheit 5 Zugriff auf einen internen oder externen Datenspeicher, der ein Datenmodell des Schweißgerätes 1 beinhaltet. Dieses Datenmodell gibt vorzugsweise die in dem Schweißgerät 1 enthaltenen Bauteile und vorzugsweise deren räumliche Lage entlang der Kühlluftstrecke 8 an. Durch Berücksichtigung dieses Datenmodells kann die Überwachungseinheit 5 die Analyse der ihr gemeldeten Temperaturverläufe T(t) verfeinern, da aus dem Datenmodell hervorgeht, wie die relative Lage der verschiedenen Bauteile 2-i zueinander innerhalb der Kühlluftstrecke 8 ist. Die aufgetretenen Betriebszustandsabweichungen der Kühlung sowie die Analyseergebnisse können bei einer möglichen Ausführungsform von der Überwachungseinheit 5 über die Netzwerkschnittstelle 12 einer zentralen Steuerung einer Anlage gemeldet werden, um die notwendigen Wartungsmaßnahmen zu veranlassen. Die Überwachungseinheit 5 kann verschiedenste Fehlerursachen bzw. Betriebszustandsabweichungen erkennen, beispielsweise dass die Zufuhr der Kühlluft in der Kühlluftstrecke 8 blockiert ist oder ein Kühlkörper im Schweißgerät 1 belegt bzw. verschmutzt ist. Weitere mögliche Fehlerzustände bzw. Fehlerursachen sind beispielsweise eine zu hohe Umgebungstemperatur T_{U} in der Umgebung des Schweißgerätes 1 oder dass einzelne Kühleinheiten defekt oder beeinträchtigt sind. Hierdurch ist es für das Wartungspersonal möglich, präventiv eine Wartung der Kühlung des Schweißgerätes 1 vorzunehmen, bevor kritische Grenztemperaturen an dem betroffenen Bauteil 2-i innerhalb des Schweißgerätes 1 erreicht werden. Bei zu hoher Umgebungstemperatur kann das Wartungspersonal für die ausreichende Kühlung der Umgebungsluft der Schweißstromquelle sorgen. Dies hat zur Folge, dass ein ungewolltes Ausfallen des Schweißgerätes 1 innerhalb der Anlage präventiv vermieden werden kann, sodass die Produktivität der Anlage gesteigert wird. Darüber hinaus wird die Lebensdauer der verschiedenen Bauteile 2-i innerhalb des Schweißgerätes 1 durch das Vermeiden zu hoher Temperaturen gesteigert. Bei Erkennen eines potentiellen Fehlers der Kühlung des Schweißgerätes 1 kann die Überwachungseinheit 5 zudem gezielt Aktuatoren innerhalb des Schweißgerätes 1 ansteuern, um Folgen des aufgetretenen Fehlers zu vermeiden. Erkennt beispielsweise die Überwachungseinheit 5 anhand der ihr gemeldeten Temperaturverläufe, dass die lokale Kühleinheit des Bauteils 2-1 innerhalb der Kühlstrecke 8 fehlerhaft ist oder vollständig ausgefallen ist, kann sie zur übergangsweisen Behebung bzw. Linderung des Fehlers den Ventilator 6 derart ansteuern, dass die Kühlung des betroffenen Bauteils 2-1 gesteigert wird. So kann beispielsweise die Drehzahl des Ventilators 6 auf den maximalen Wert erhöht werden. Nach Behebung der Fehlerursache, die zu dem gesteigerten Temperaturverlauf geführt hat, kann die Überwachungseinheit 5 dann den Ventilator 6 wieder normal betreiben.
Anhand des Ergebnisses der Analyse kann auch eine Meldung an den Nutzer/Bediener erfolgen, damit dieser eine gezielte Überprüfung des betroffenen Bauteils 2-1 vornimmt. Entsprechend können auch Maßnahmen zur Fehlerbehebung vorgeschlagen werden, wie z.B. Schraubverbindungen zu Wärmesenken nachziehen oder lokale Verschmutzung entfernen. Verschmutzungen können beispielsweise aber auch durch eine Änderung der Laufrichtung des Ventilators 6 entfernt werden. Es kann aber auch mithilfe eines Aktuators eine Druckluft oder ein für den Schweißprozess erforderliches Schutzgas durch einen Filter geblasen werden, sodass dieser gereinigt wird und wieder mehr Zuluft angesaugt werden kann.

Die Temperatursensoren 3-1, 3-2 können auch derart angeordnet sein, dass diese eine Temperatur am Eingang und am Ausgang der Kühlluftstecke 8 der kühlenden Luft L erfassen. Es können dafür auch zusätzliche Temperatursensoren eingesetzt werden. Daraus kann eine Wärmebilanz von der Überwachungseinheit 5 ermittelt werden und Rückschlüsse auf mögliche Fehler gezogen werden. Dafür kann ein Datenmodell, Referenzwerte, usw. - wie bereits beschrieben - herangezogen werden.

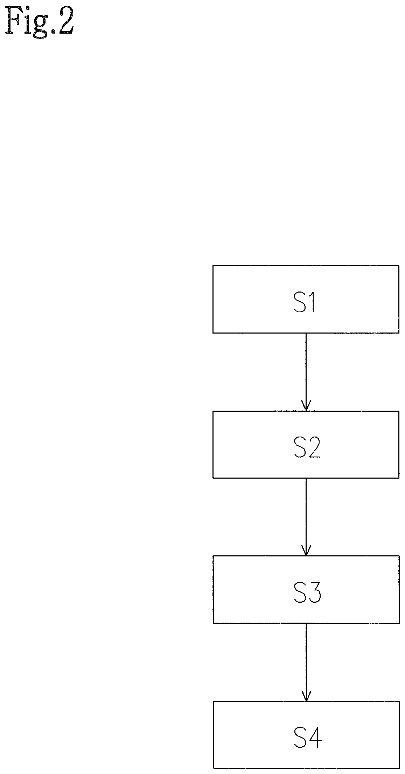

Fig. 2 zeigt ein Ablaufdiagramm zur Darstellung eines Ausführungsbeispiels des erfindungsgemäßen Verfahrens zum Überwachen eines Betriebszustandes einer Gerätkühlung bei einem Gerät, beispielsweise dem in Fig. 1 dargestellten Schweißgerät 1.

In einem ersten Schritt S1 wird ein Betriebstemperaturverlauf T(t) von mindestens einem Bauteil 2-i des Gerätes 1 erfasst. In einem weiteren Schritt S2 wird der Betriebszustand der Gerätkühlung auf Basis des mindestens einen erfassten Betriebstemperaturverlaufs und einer von dem Gerät 1 bereitgestellten Leistung ermittelt.

Bei einer Abweichung des ermittelten Betriebszustandes der Gerätkühlung von einem normalen Betriebszustand der Gerätkühlung werden bei einer möglichen Ausführungsform des erfindungsgemäßen Verfahrens die erfassten Betriebstemperaturverläufe T(t) der Bauteile zum Erkennen mindestens einer potentiellen Ursache der Betriebszustandsabweichung der Gerätkühlung in Schritt S3 analysiert.

Bei einer weiteren möglichen Ausführungsform wird die Betriebszustandsabweichung der Gerätkühlung und mindestens eine erkannte potentielle Ursache der Betriebszustandsabweichung über eine Nutzerschnittstelle oder eine Netzwerkschnittstelle des Gerätes 1 im Schritt S4 ausgegeben. Vorzugsweise werden zusätzlich Anweisungen zur Behebung der entsprechenden Ursache über die Nutzerschnittstelle und/oder die Netzwerkschnittstelle an einen Nutzer oder eine zentrale Steuerung im Schritt S4 ausgegeben.

Nach Durchführung der Wartungsmaßnahme kann die Überwachungseinheit 5 eine Überprüfung durchführen, ob die entsprechende Wartungsmaßnahme zu einer Behebung der Betriebszustandsabweichung der Gerätkühlung geführt hat und somit die Wartungsmaßnahme erfolgreich war.

Das in Fig. 2 dargestellte Verfahren wird vorzugsweise von einem Überwachungsprogramm ausgeführt, das auf einem Mikroprozessor der Überwachungseinheit 5 abläuft. Dieses Überwachungsprogramm kann bei einer möglichen Ausführungsform über die Netzwerkschnittstelle 12 des Gerätes 1 in einen Programmspeicher der Überwachungseinheit 5 geladen werden. Bei einer möglichen Ausführungsform wird das entsprechende Überwachungsprogramm über ein Netzwerk von einem Server geladen, der beispielsweise von dem Hersteller des Gerätes 1 betrieben wird. Neben dem Programmspeicher für das Überwachungsprogramm verfügt die Überwachungseinheit 5 bei einer weiteren möglichen Ausführungsform über einen weiteren Datenspeicher zum Speichern des Datenmodells der in dem Gerät 1 enthaltenen Bauteile bzw. Baugruppen. Dieses Datenmodell des Gerätes 1 kann bei einer möglichen Ausführungsform ebenfalls über die Netzwerkschnittstelle 12 von einer Datenbank bzw. einem Server runtergeladen werden. Das geladene Datenmodell kann unterschiedliche Konfigurationen bzw. Varianten des Gerätes 1 berücksichtigen. Das Laden des Überwachungsprogramms und/oder des Datenmodells erfolgt bei einer möglichen Ausführungsform in Reaktion auf eine Eingabe eines Nutzers über die Nutzerschnittstelle 11 des Gerätes 1. Bei dem in Fig. 1 dargestellten Ausführungsbeispiel ist die Überwachungseinheit 5 in dem Gerät 1 integriert. Bei einer alternativen Ausführungsform kann die Überwachungseinheit 5 auch in einer zentralen Steuerung einer Anlage integriert sein, die über ein Netzwerk mit einem oder mehreren Geräten 1 verbunden ist. Bei einer möglichen Ausführungsform kann die zentrale Steuerung der Anlage verschiedene Wartungspläne für verschiedene Geräte, insbesondere Schweißgeräte 1, entsprechend den gemeldeten Temperaturverläufen und Betriebszustandsabweichungen der Gerätkühlungen dynamisch anpassen. Bei einer möglichen Ausführungsform ist das in Fig. 1 dargestellte Gerät 1 in einer Anlage, beispielsweise einer Fertigungsanlage, integriert. Bei einer alternativen Ausführungsform kann das Gerät 1 auch ein mobiles tragbares Gerät für den mobilen Einsatz sein. Das Gerät 2 ist ein Energiegerät, das elektrische Leistung in Form von Gleichstrom oder Wechselstrom bereitstellt. Das Gerät 1 ist bei einer möglichen Ausführungsform ein Schweißgerät, wie es schematisch in Fig. 1 dargestellt ist. Bei alternativen Ausführungsformen ist das Gerät 1 ein Batterieladegerät oder ein Wechselrichter einer Photovoltaikanlage zur Umwandlung von Gleich- in Wechselstrom.

## Patentansprüche

1. Gerät (1) zur Bereitstellung einer elektrischen Leistung, wobei das Gerät (1) aufweist:
integrierte Temperatursensoren (3-1, 3-2), welche Betriebstemperaturverläufe von Bauteilen (2-1, 2-2) des Gerätes (1) erfassen und
eine Überwachungseinheit (5), welche auf Basis der erfassten Betriebstemperaturverläufe und der Leistung den Betriebszustand einer Gerätkühlung des Gerätes (1) überwacht, **dadurch gekennzeichnet, dass**
die Gerätkühlung des Gerätes (1) mindestens eine Lüftungseinheit (6) als Bauteil aufweist, die Kühlluft aus der Umgebung des Gerätes (1) weiteren Bauteilen (2-1, 2-2) des Gerätes (1) entlang einer Kühlluftstrecke (8) innerhalb eines Gehäuses des Gerätes (1) zuführt, wobei die Überwachungseinheit (5) Zugriff auf einen internen oder externen Datenspeicher hat, der ein Datenmodell der in dem Gerät (1) enthaltenen Bauteile (2-1, 2-2, 6) und deren räumliche Lage entlang der Kühlluftstrecke (8), speichert, wobei die Überwachungseinheit (5) bei Abweichung des überwachten Betriebszustandes der Gerätkühlung von einem normalen Betriebszustand der Gerätkühlung dazu ausgebildet ist, die erfassten Betriebstemperaturverläufe verschiedener Bauteile (2-1, 2-2) zur Ermittlung mindestens einer potentiellen Ursache der Betriebszustandsabweichung zu analysieren, wobei die Überwachungseinheit (5) das in dem Datenspeicher gespeicherte Datenmodell berücksichtigt.

2. Gerät nach Anspruch 1,
wobei mindestens ein weiterer Temperatursensor (9) eine Umgebungstemperatur in der Umgebung des Gerätes (1) erfasst und an die Überwachungseinheit (5) des Gerätes (1) meldet.

3. Gerät nach Anspruch 1 oder 2,
wobei das Gerät (1) eine Nutzerschnittstelle (11) aufweist, welche eine Anzeigeeinheit zur Anzeige der Betriebszustandsabweichung der Gerätkühlung, der ermittelten Ursache der Betriebszustandsabweichung und Anweisungen zur Behebung der ermittelten Ursache der Betriebszustandsabweichung der Gerätkühlung aufweist.

4. Gerät nach Anspruch 3,
wobei die Nutzerschnittstelle (11) eine Eingabeeinheit zur Einstellung des Stromes durch einen Nutzer und/oder durch eine zentrale Steuerung einer Anlage aufweist.

5. Gerät nach einem der vorangehenden Ansprüche 1 bis 4,
wobei die Bauteile (2-1, 2-2) des Gerätes (1) elektronische und/oder elektromechanische Bauteile sind, wobei zugehörige Kühleinheiten zur Kühlung des jeweiligen Bauteils (2-1, 2-2) vorgesehen sind.

6. Gerät nach einem der vorangehenden Ansprüche 1 bis 5,
wobei Bauteile (2-1, 2-2) entlang der Kühlluftstrecke (8) zugehörige Temperatursensoren (3-1, 3-2) aufweisen, die einen Betriebstemperaturverlauf an den jeweiligen Bauteilen (2-1, 2-2) erfassen und an die Überwachungseinheit (5) des Gerätes (1) melden.

7. Gerät nach einem der vorangehenden Ansprüche 1 bis 6,
wobei eine Strommesseinheit (10) des Gerätes (1) den eingestellten Strom misst und an die Überwachungseinheit (5) meldet.

8. Gerät nach einem der vorangehenden Ansprüche 1 bis 7,
wobei die Überwachungseinheit (5) in Abhängigkeit von dem momentanen Betriebszustand der Gerätkühlung eine Kühleinheit und/oder die Lüftungseinheit (6) ansteuert.

9. Gerät nach einem der vorangehenden Ansprüche 1 bis 8,
wobei die Überwachungseinheit (5) über eine Netzwerkschnittstelle (12) des Gerätes (1) den Betriebszustand der Gerätkühlung an eine zentrale Steuerung einer Anlage meldet.

10. Verfahren zum Überwachen eines Betriebszustandes einer Gerätkühlung bei einem Gerät (1) mit den Schritten:
(a) Erfassen (S1) eines Betriebstemperaturverlaufs von Bauteilen (2) des Gerätes (1) und
(b) Ermitteln (S2) des Betriebszustandes der Gerätkühlung auf Basis der erfassten Betriebstemperaturverläufe und einer von dem Gerät (1) bereitgestellten elektrischen Leistung;
(c) Analysieren (S3) der erfassten Betriebstemperaturverläufe der Bauteile (2) bei einer Abweichung des ermittelten Betriebszustandes der Gerätkühlung von einem normalen Betriebszustand der Gerätkühlung zum Erkennen mindestens einer potentiellen Ursache der Betriebszustandsabweichung der Gerätkühlung, wobei ein gespeichertes Datenmodell der in dem Gerät (1) enthaltenen Bauteile (2) und deren räumliche Lage entlang einer Kühlluftstrecke (8) berücksichtigt wird.

11. Verfahren nach Anspruch 10,
wobei eine Betriebszustandsabweichung der Gerätkühlung und mindestens eine erkannte potentielle Ursache der Betriebszustandsabweichung sowie Anweisungen zur Behebung der entsprechenden Ursache über eine Nutzerschnittstelle (11) und/oder eine Netzwerkschnittstelle (12) des Gerätes (1) ausgegeben (S4) werden.

## Claims

1. Device (1) for providing electric power, wherein the device (1) has:
integrated temperature sensors (3-1, 3-2), which detect operating temperature progressions of components (2-1, 2-2) of the device (1), and
a monitoring unit (5), which monitors the operating state of a device cooling arrangement of the device (1) on the basis of the detected operating temperature progressions and the power, **characterised in that**
the device cooling arrangement of the device (1) has at least one ventilation unit (6) as a component, which delivers cooling air from the vicinity of the device (1) to other components (2-1, 2- 2) of the device (1) along a cooling air path (8) inside a housing of the device (1), wherein the monitoring unit (5) has access to an internal or external data memory which stores a data model of the components (2-1, 2-2, 6) contained in the device (1) and their spatial position along the cooling air path (8), wherein in the event of the deviation of the monitored operating state of the device cooling arrangement from a normal operating state of the device cooling arrangement the monitoring unit (5) is provided to analyse the detected operating temperature progressions of various components (2-1, 2-2) in order to determine at least one potential cause of the operating state deviation, wherein the monitoring unit (5) takes account of the data model stored in the data memory.

2. Device according to claim 1, wherein at least a further temperature sensor (9) detects an ambient temperature in the vicinity of the device (1) and reports it to the monitoring unit (5) of the device (1).

3. Device according to claim 1 or 2, wherein the device (1) has a user interface (11) which has a display unit for displaying the operating state progression of the device cooling arrangement, the determined cause of the operating state deviation and instructions for eliminating the identified cause of the operating state deviation of the device cooling arrangement.

4. Device according to claim 3, wherein the user interface (11) has an input unit for setting the current by a user and/or by a central control device of an installation.

5. Device according to any one of the preceding claims 1 to 4, wherein the components (2-1, 2-2) of the device (1) are electronic and/or electromechanical components, wherein associated cooling units are provided for cooling the respective component (2-1, 2-2).

6. Device according to any one of the preceding claims 1 to 5, wherein components (2-1, 2-2) have associated temperature sensors (3-1, 3-2) along the cooling air path (8) which detect an operating temperature progression at the respective components (2-1, 2-2) and report it to the monitoring unit (5) of the device (1).

7. Device according to any one of the preceding claims 1 to 6, wherein a current measuring unit (10) of the device (1) measures the set current and reports it to the monitoring unit (5).

8. Device according to any one of the preceding claims 1 to 7, wherein depending on the momentary operating state of the device cooling arrangement the monitoring unit (5) operates a cooling unit and/or the ventilation unit (6).

9. Device according to any one of the preceding claims 1 to 8, wherein the monitoring unit (5) reports the operating state of the device cooling arrangement to a central control device of an installation via a network interface (12) of the device (1).

10. Method of monitoring an operating state of a device cooling arrangement in the case of a device (1) with the steps:
(a) detecting (S1) an operating temperature progression of components (2) of the device (1) and
(b) determining (S2) the operating state of the device cooling arrangement on the basis of the detected operating temperature progressions and electric power provided by means of the device (1);
(c) analysing (S3) the detected operating temperature progressions of the components (2) in the event of a deviation of the determined operating state of the device cooling arrangement from a normal operating state of the device cooling arrangement for identifying at least one potential cause of the operating state deviation of the device cooling arrangement, wherein a stored data model of the components (2) contained in the device (1) and their spatial position along a cooling air path (8) is taken into account.

11. Method according to claim 10,
wherein an operating state deviation of the device cooling arrangement and at least one identified potential cause of the operating state deviation as well as instructions for eliminating the respective cause are output (S4) via a user interface (11) and/or a network interface (12) of the device (1) .

## Revendications

1. Appareil (1) destiné à fournir une puissance électrique, l'appareil (1) comportant :
des capteurs de température (3-1, 3-2) intégrés, qui détectent des variations de température de fonctionnement de composants (2-1, 2-2) de l'appareil (1) et
une unité de surveillance (5), qui surveille l'état de fonctionnement d'un refroidissement de l'appareil (1) sur la base des variations de température de fonctionnement détectées et de la puissance, **caractérisé en ce que**
le refroidissement de l'appareil (1) comporte au moins une unité de ventilation (6) comme composant, qui alimente de l'air de refroidissement depuis l'environnement de l'appareil (1) dans d'autres composants (2-1, 2-2) de l'appareil (1) le long d'une voie d'air de refroidissement (8) située à l'intérieur d'un boîtier de l'appareil (1), l'unité de surveillance (5) ayant accès à une mémoire de données interne ou externe, dans laquelle est enregistré un modèle de données des composants (2-1, 2-2, 6) compris dans l'appareil (1) et de leur position dans l'espace le long de la voie d'air de refroidissement (8), l'unité de surveillance (5) étant conçue pour, en cas d'écart de l'état de fonctionnement surveillé du refroidissement par rapport à un état de fonctionnement normal du refroidissement, analyser les variations de température de fonctionnement détectées de différents composants (2-1, 2-2) pour déterminer au moins une cause potentielle de l'écart entre les états de fonctionnement, l'unité de surveillance (5) prenant en compte le modèle de données enregistré dans la mémoire de données.

2. Appareil selon la revendication 1, dans lequel au moins un autre capteur de température (9) détecte la température ambiante dans l'environnement de l'appareil (1) et la transmet à l'unité de surveillance (5) de l'appareil (1).

3. Appareil selon la revendication 1 ou 2, dans lequel l'appareil (1) comporte une interface utilisateur (11), qui comporte une unité d'affichage destinée à afficher l'écart entre les états de fonctionnement du refroidissement, la cause déterminée de l'écart entre les états de fonctionnement et des instructions pour éliminer la cause déterminée de l'écart entre les états de fonctionnement du refroidissement.

4. Appareil selon la revendication 3, dans lequel l'interface utilisateur (11) comporte une unité d'entrée destinée au réglage du courant par un utilisateur et/ou par une commande centrale d'une installation.

5. Appareil selon l'une des revendications précédentes 1 à 4, dans lequel les composants (2-1, 2-2) de l'appareil (1) sont des composants électroniques et/ou électromécaniques, des unités de refroidissement associées étant prévues pour le refroidissement du composant (2-1, 2-2) respectif.

6. Appareil selon l'une des revendications précédentes 1 à 5, dans lequel des composants (2-1, 2-2) le long de la voie d'air de refroidissement (8) comportent des capteurs de température (3-1, 3-2) associés, qui détectent une variation de température de fonctionnement sur les composants (2-1, 2-2) respectifs et la transmettent à l'unité de surveillance (5) de l'appareil (1).

7. Appareil selon l'une des revendications précédentes 1 à 6, dans lequel une unité de mesure du courant (10) de l'appareil (1) mesure le courant réglé et le transmet à l'unité de surveillance (5).

8. Appareil selon l'une des revendications précédentes 1 à 7, dans lequel l'unité de surveillance (5) commande une unité de refroidissement et/ou l'unité de ventilation (6) en fonction de l'état de fonctionnement actuel du refroidissement.

9. Appareil selon l'une des revendications précédentes 1 à 8, dans lequel l'unité de surveillance (5) transmet l'état de fonctionnement du refroidissement à une commande centrale d'une installation par le biais d'une interface réseau (12) de l'appareil (1).

10. Procédé de surveillance d'un état de fonctionnement d'un refroidissement pour un appareil (1), comprenant les étapes consistant à :
(a) détecter (S1) une variation de température de fonctionnement de composants (2) de l'appareil (1) et
(b) déterminer (S2) l'état de fonctionnement du refroidissement sur la base des variations de température de fonctionnement détectées et d'une puissance électrique fournie par l'appareil (1) ;
(c) analyser (S3) les variations de température de fonctionnement détectées des composants (2) en cas d'écart de l'état de fonctionnement déterminé du refroidissement par rapport à un état de fonctionnement normal du refroidissement pour identifier au moins une cause potentielle de l'écart entre les états de fonctionnement du refroidissement, un modèle de données enregistré des composants (2) compris dans l'appareil (1) et de leur position dans l'espace le long d'une voie d'air de refroidissement (8) étant pris en compte.

11. Procédé selon la revendication 10, dans lequel un écart entre les états de fonctionnement du refroidissement et au moins une cause potentielle détectée de l'écart entre les états de fonctionnement ainsi que des instructions pour éliminer la cause correspondante sont sortis (S4) par le biais d'une interface utilisateur (11) et/ou d'une interface réseau (12) de l'appareil (1).
